# EUROPEAN PATENT APPLICATION

(11) **EP 4 651 639 A1**
(43) Date of publication of application: **19.11.2025**
(21) Application number: 23915902.3
(22) Date of filing: 10.01.2023
(51) Int. Cl.: H05K 1/18, H05K 1/02

(54) **SENSOR MODULE AND SENSOR DEVICE**

(71) Applicant: SMC Corporation, Tokyo 104-0031 (JP)
(72) Inventor: OZAKI, Norimasa, Ibaraki 300-2493 (JP); OSHIMA, Yuta, Ibaraki 300-2493 (JP)
(74) Representative: Keil & Schaafhausen Patentanwälte PartGmbB
(86) International application number: PCT/JP2023/000325
(87) International publication number: WO 2024/150278

(57) **Abstract**

This sensor module (12) comprises an intermediate member (18), a flexible substrate (16) that is wound around the intermediate member, and a sensor element (20) that comprises a lead part (34) that passes through the flexible substrate and is inserted into the intermediate member, wherein: the flexible substrate is wound around the intermediate member so that a first portion (24) of the flexible substrate is superimposed on and in contact with a second portion (26) that differs from the first portion of the flexible substrate; and the lead part passes through the first portion and the second portion and is inserted into the intermediate member.

## Description

### TECHNICAL FIELD

The present invention relates to a sensor module and a sensor device.

### BACKGROUND ART

JP 2000-165034 A describes a flexible printed wiring board (flexible circuit board) which is a printed circuit board having flexibility.

### SUMMARY OF THE INVENTION

There is a long-awaited need for a technology for easily constituting a satisfactory sensor module by using a flexible circuit board.

The present invention has the object of solving the aforementioned problems.

A first aspect of the present invention is characterized by a sensor module including an intermediate member, a flexible circuit board wound around the intermediate member, and a sensor element including a lead portion penetrating the flexible circuit board and inserted into the intermediate member, wherein the flexible circuit board is wound around the intermediate member in a manner so that a first portion of the flexible circuit board overlaps and contacts a second portion of the flexible circuit board, the second portion being different from the first portion, and the lead portion penetrates the first portion and the second portion and is inserted into the intermediate member.

A second aspect of the present invention is characterized by a sensor module including an intermediate member, a flexible circuit board wound around the intermediate member, and a sensor element including a lead portion penetrating the flexible circuit board and inserted into the intermediate member, wherein the flexible circuit board is wound around the intermediate member in a manner so that a first end portion of the flexible circuit board and a second end portion of the flexible circuit board approach each other, and the lead portion includes a first lead penetrating the first end portion and inserted into the intermediate member, and a second lead penetrating the second end portion and inserted into the intermediate member.

A third aspect of the present invention is characterized by a sensor device including the sensor module according to the first aspect or the second aspect, and a housing configured to accommodate at least the flexible circuit board and the intermediate member of the sensor module.

According to the present invention, it is possible to provide a sensor module and a sensor device that can be configured favorably and easily even when a flexible circuit board is used.

### BRIEF DESCRIPTION OF DRAWINGS

[FIG. 1] FIG. 1 is a perspective view of a sensor device according to a first embodiment;
[FIG. 2] FIG. 2 is an exploded perspective view of the sensor device;
[FIG. 3] FIG. 3 is an exploded perspective view of a sensor module;
[FIG. 4] FIG. 4 is a cross-sectional view taken along line IV-IV of FIG. 1;
[FIG. 5] FIG. 5 is a cross-sectional view taken along line V-V of FIG. 4;
[FIG. 6] FIG. 6 is a perspective view of the sensor module;
[FIG. 7] FIG. 7 is a diagram for explaining a sensor module according to Modification 1-1;
[FIG. 8] FIG. 8 is a diagram for explaining a sensor device according to Modification 1-3;
[FIG. 9] FIG. 9 is a perspective view of a sensor module according to a second embodiment;
[FIG. 10] FIG. 10 is a cross-sectional view taken along line X-X of FIG. 9;
[FIG. 11] FIG. 11 is a perspective view illustrating a sensor module according to Modification 2-1; and
[FIG. 12] FIG. 12 is a cross-sectional view taken along line XII-XII of FIG. 11.

### DETAILED DESCRIPTION OF THE INVENTION

In the case that a sensor element is provided on a flexible circuit board, it is difficult to position the sensor element because the flexible circuit board has flexibility. If the sensor element is not securely positioned, the performance of the sensor device is adversely affected.

### [First Embodiment]

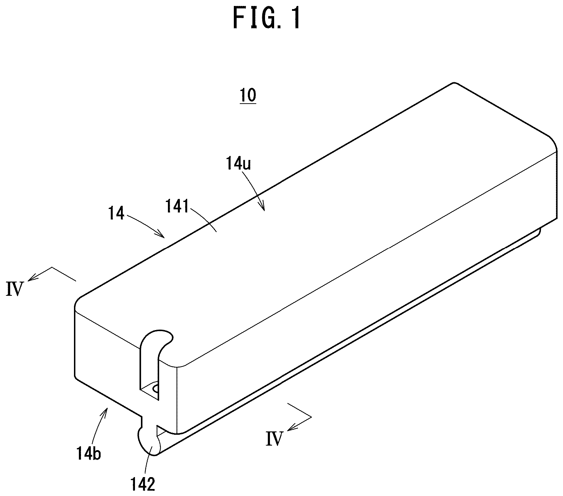

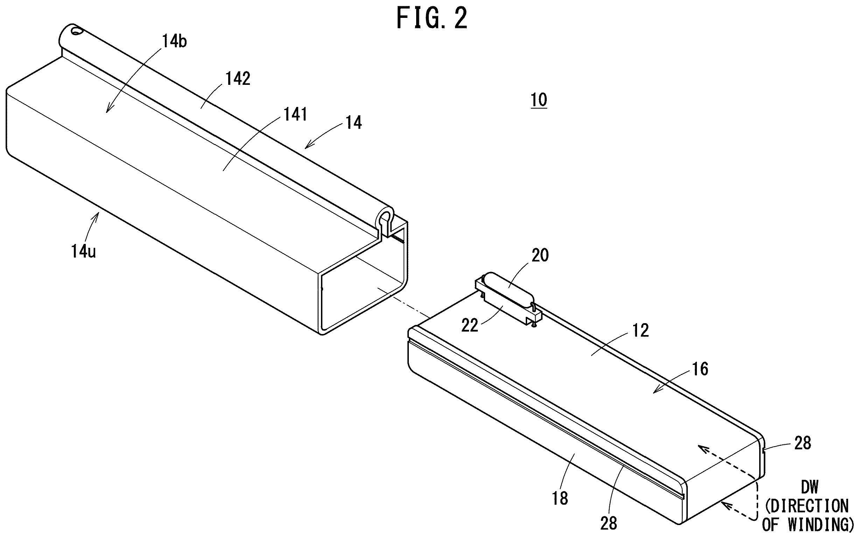

FIG. 1 is a perspective view of a sensor device 10 according to a first embodiment. FIG. 2 is an exploded perspective view of the sensor device 10. Note that FIG. 1 is a top perspective view of a housing 14 described later. In contrast, FIG. 2 is a bottom perspective view of the housing 14.

The sensor device 10 includes a sensor module 12 and the housing 14. The sensor module 12 is accommodated in the housing 14. The sensor device 10 is, for example, an automatic switch (cylinder sensor) for detecting the position of a piston provided in an air cylinder, but is not limited thereto.

The housing 14 is a casing that accommodates the sensor module 12. The housing 14 includes an upper part 14u shown in FIG. 1 and a lower part 14b shown in FIG. 2. The housing 14 includes a circuit board accommodation portion 141 and a sensor accommodation portion 142.

The circuit board accommodation portion 141 has a rectangular parallelepiped shape. The circuit board accommodation portion 141 accommodates a flexible circuit board 16 and an intermediate member 18, which will be described later. In the present embodiment, a top surface of the circuit board accommodation portion 141 forms the upper part 14u.

The sensor accommodation portion 142 protrudes downward from the circuit board accommodation portion 141. In the present embodiment, the sensor accommodation portion 142 is included in the lower part 14b. The sensor accommodation portion 142 accommodates a sensor element 20 and a spacer 22 described later. The sensor accommodation portion 142 can also function as an attachment portion for attaching the sensor device 10 to the air cylinder by engaging with a groove portion formed in the air cylinder described above, for example.

The sensor module 12 includes the flexible circuit board 16, the intermediate member 18, the sensor element 20, and the spacer 22.

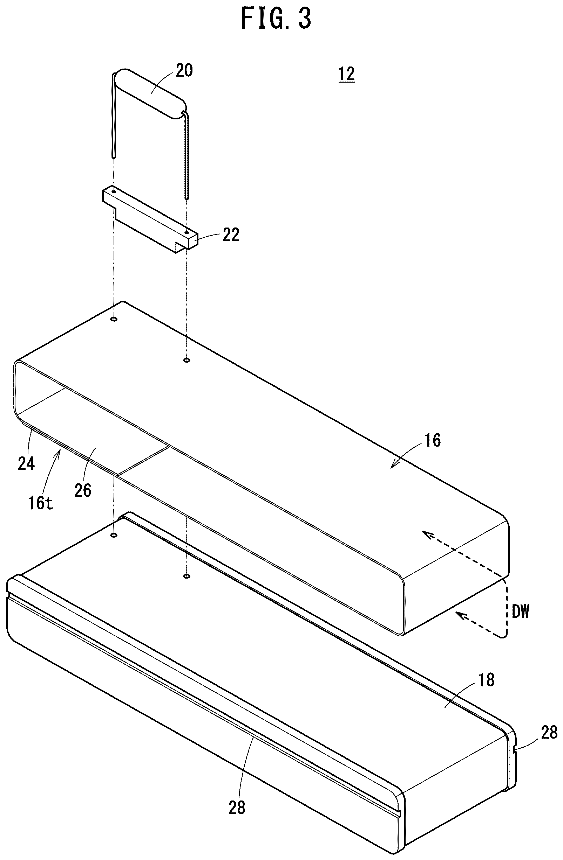

FIG. 3 is an exploded perspective view of the sensor module 12.

The flexible circuit board 16 is a circuit board having flexibility. Although not specifically shown, a predetermined electric circuit is formed on the flexible circuit board 16. The sensor element 20 constitutes a part of the electric circuit. As shown in FIG. 2, the flexible circuit board 16 is wound around the intermediate member 18. A direction of winding DW shown in FIG. 2 indicates a direction in which the flexible circuit board 16 is wound around the intermediate member 18. The direction of winding DW of the flexible circuit board 16 with respect to the intermediate member 18 is along the longitudinal direction of the flexible circuit board 16.

The flexible circuit board 16 wound around the intermediate member 18 has two portions (24, 26) that overlap and contact each other. In the present embodiment, one of these two portions is also referred to as a first portion 24. In the present embodiment, the other of the two portions is also referred to as a second portion 26.

The first portion 24 is located at one end portion 16t of the flexible circuit board 16. The second portion 26 is a portion different from the first portion 24. The second portion 26 is located at another end portion of the flexible circuit board 16. The first portion 24 and the second portion 26 overlap each other in plan view. The second portion 26 is covered with the first portion 24.

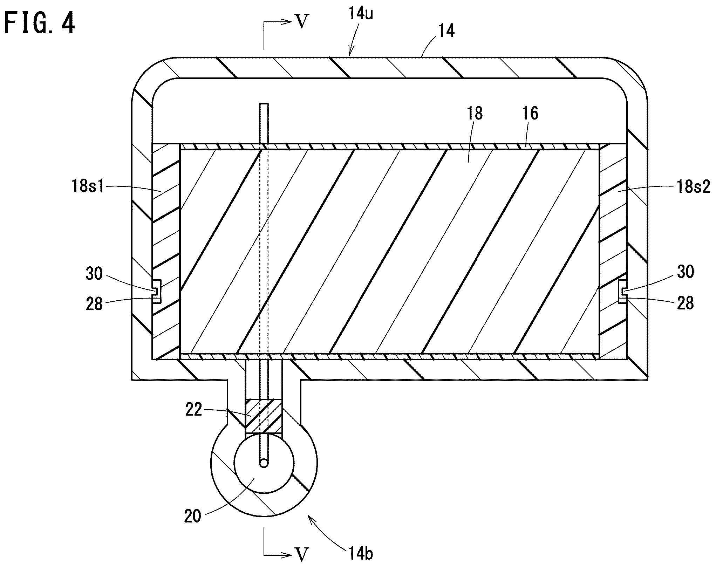

The intermediate member 18 is a member that is harder than the flexible circuit board 16. The intermediate member 18 is made of, for example, a resin material such as acrylic. The intermediate member 18 has, for example, a plate shape. The intermediate member 18 is provided with an engagement portion 28 that engages with an engagement portion 30 (see FIG. 4) described later.

FIG. 4 is a cross-sectional view taken along line IV-IV of FIG. 1.

The engagement portion 28 is located, for example, in a portion of the intermediate member 18 that is not covered with the flexible circuit board 16. The engagement portion 28 is formed by, for example, a concave portion, but is not limited thereto. The intermediate member 18 may include a plurality of the engagement portions 28. The intermediate member 18 has, for example, side portions 18s1 and 18s2 that are not covered with the flexible circuit board 16. The engagement portion 28 may be provided on each of the side portions 18s1 and the side 18s2.

The engagement portion 28 engages with an engagement portion (engaged portion) 30 provided in the housing 14. The engagement portion 30 is formed of, for example, a convex portion, but is not limited thereto. The housing 14 may be provided with the number of engagement portions 30 corresponding to the number of engagement portions 28. The engagement between the engagement portions 28 and the engagement portions 30 positions the intermediate member 18 with respect to the housing 14.

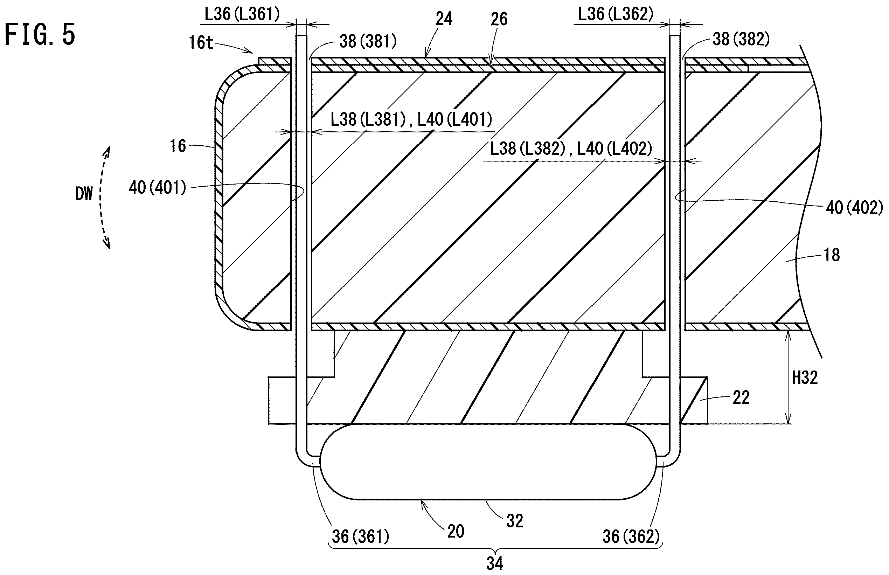

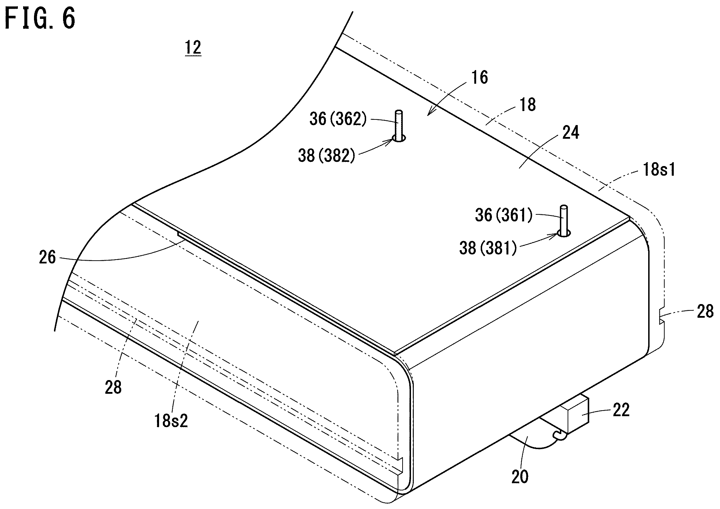

FIG. 5 is a cross-sectional view taken along line V-V of FIG. 4. Note that only a part of the cross section of the sensor module 12 is shown in FIG. 5. FIG. 6 is a perspective view of the sensor module 12. Note that only a part of the sensor module 12 is shown in FIG. 6.

The sensor element 20 includes a main body portion 32 and a lead portion 34. The sensor element 20 is, for example, a magnetic sensor, but is not limited thereto. The sensor element 20 may be, for example, a temperature sensor, a flow rate sensor, a semiconductor sensor, or the like. The sensor element 20 constitutes a part of the electric circuit described above.

The main body portion 32 is a portion for detecting a predetermined physical quantity to be detected by the sensor element 20. For example, when the sensor element 20 is a magnetic sensor, the main body portion 32 detects a magnetic force.

The lead portion 34 electrically connects the flexible circuit board 16 and the main body portion 32. More specifically, the lead portion 34 electrically connects a conductor pattern (not shown) constituting a part of the electric circuit formed on the flexible circuit board 16, and the main body portion 32. The lead portion 34 includes two leads 36 (361, 362) extending from the main body portion 32. That is, the lead portion 34 includes a first lead 361 and a second lead 362. Although not shown, each of the first lead 361 and the second lead 362 is fixed to the flexible circuit board 16 by, for example, soldering, and is electrically connected to the above-described conductor pattern. The number of leads 36 provided in the lead portion 34 is not limited to two.

The sensor element 20 outputs a detection signal corresponding to a predetermined physical quantity via a conductor pattern formed on the flexible circuit board 16. The detection signal is transmitted to the outside of the sensor device 10 via a wireless communication circuit (not illustrated) formed on the flexible circuit board 16, for example. The electric power for the sensor element 20 to generate and output the detection signal may be supplied to the sensor element 20 from, for example, a battery, a capacitor, or the like, but is not limited thereto.

The spacer 22 is a member disposed between the main body portion 32 and the flexible circuit board 16. The main body portion 32 of the sensor element 20 may be fixed to the spacer 22. The provision of the spacer 22 can sufficiently secure a separation distance H32 between the main body portion 32 and the flexible circuit board 16. The separation distance H32 is a distance in a normal direction of the main surface of the flexible circuit board 16. The lead portion 34 described above penetrates the spacer 22.

The spacer 22 and the overlapping portion of the first portion 24 and the second portion 26, are arranged so as to sandwich the intermediate member 18. The lead portion 34 that has penetrated through the spacer 22, penetrates through the intermediate member 18 and further penetrates through the first portion 24 and the second portion 26.

More specifically, the flexible circuit board 16 has through holes 38. In the present embodiment, the number of the through holes 38 (381, 382) formed in the flexible circuit board 16 corresponds to the number of the leads 36 provided in the lead portion 34. That is, in the present embodiment, the two through holes 38 are formed in the flexible circuit board 16. One of the two through holes 38 is also referred to as a first through hole 381 in the following description. Another of the two through holes 38 is also referred to as a second through hole 382. The first through hole 381 penetrates the first portion 24 and the second portion 26. The second through hole 382 also penetrates the first portion 24 and the second portion 26. Insertion holes 40 are formed in the intermediate member 18. In the present embodiment, the number of the insertion holes 40 (401, 402) formed in the intermediate member 18 corresponds to the number of the leads 36 provided in the lead portion 34. That is, two insertion holes 40 are formed in the intermediate member 18. One of the two insertion holes 40 is also referred to as a first insertion hole 401 in the following description. Another of the two insertion holes 40 is also referred to as a second insertion hole 402. The first insertion hole 401 and the first through hole 381 communicate with each other. The second insertion hole 402 and the second through hole 382 communicate with each other. The first lead 361 provided in the lead portion 34 is inserted into the first through hole 381 via the first insertion hole 401. The second lead 362 provided in the lead portion 34 is inserted into the second through hole 382 via the second insertion hole 402.

The leads 36 are inserted into the intermediate member 18, so that the sensor element 20 is positioned with respect to the intermediate member 18. The intermediate member 18 is positioned with respect to the housing 14 by the engagement portion 28. Consequently, according to the present embodiment, the sensor element 20 is positioned with respect to the housing 14. Moreover, according to the present embodiment, the lead portion 34 protrudes from the overlapping portion of the first portion 24 and the second portion 26 (see also FIGS. 5 and 6). Accordingly, it is possible to easily solder the flexible circuit board 16 and the parts of the lead portion 34 protruding from the overlapping portion of the first portion 24 and the second portion 26.

The sensor element 20 attached to the intermediate member 18 via the flexible circuit board 16 functions as a fixture for fixing the flexible circuit board 16 to the intermediate member 18. Accordingly, the flexible circuit board 16 is positioned with respect to the intermediate member 18. As a result, the positioning of the flexible circuit board 16 with respect to the housing 14 is also achieved. Since the positioning of the flexible circuit board 16 with respect to the intermediate member 18 is achieved by the sensor element 20, for example, a screw or the like for fixing the flexible circuit board 16 to the intermediate member 18 is not required. Therefore, according to the present embodiment, the number of components required for manufacturing the sensor module 12 can be reduced.

The through holes 38 are formed at predetermined positions of the flexible circuit board 16 before the sensor element 20 is attached to the flexible circuit board 16. The insertion holes 40 are formed at predetermined positions of the intermediate member 18 before the sensor element 20 is attached to the intermediate member 18 via the flexible circuit board 16. In this case, the through holes 38 and the insertion holes 40 also function as markers when the intermediate member 18 and the flexible circuit board 16 are positioned. That is, by winding the flexible circuit board 16 around the intermediate member 18 so that the through holes 38 and the insertion holes 40 communicate with each other, the flexible circuit board 16 is more accurately positioned with respect to the intermediate member 18. Further, the positioning of the sensor element 20 with respect to the intermediate member 18 is achieved more accurately by inserting the leads 36 of the sensor element 20 into the insertion holes 40 formed in advance.

It is preferable for a diameter L38 (L381, L382) of the through holes 38 to be larger than a diameter L36 (L361, L362) of the leads 36 inserted into the through holes 38. In other words, the diameter L381 of the first through hole 381 is preferably larger than the diameter L361 of the first lead 361. The diameter L382 of the second through hole 382 is preferably larger than the diameter L362 of the second lead 362. This facilitates insertion of the leads 36 into the through holes 38.

Also, it is preferable for a diameter L40 (L401, L402) of the insertion holes 40 to be larger than the diameter L36 of the leads 36 inserted into the insertion holes 40. In other words, the diameter L401 of the first insertion hole 401 is preferably larger than the diameter L361 of the first lead 361. Similarly, the diameter L402 of the second insertion hole 402 is preferably larger than the diameter L362 of the second lead 362. This facilitates the insertion of the leads 36 into the insertion holes 40.

In the present embodiment, the diameter L381 of the first through hole 381 and the diameter L401 of the first insertion hole 401 are equal to each other, but the present invention is not limited thereto. Similarly, in the present embodiment, the diameter L382 of the second through hole 382 and the diameter L402 of the second insertion hole 402 are equal to each other, but the present invention is not limited thereto.

It is preferable for the lead 36 to penetrate through the end portion 16t of the flexible circuit board 16. In other words, it is preferable for at least one of the first through hole 381 and the second through hole 382 to be located at the end portion 16t of the flexible circuit board 16. Thus, the end portion 16t is fixed by the sensor element 20. As a result, the end portion 16t is prevented from being turned up.

In the present embodiment, the case that the portion where the first portion 24 and the second portion 26 overlap each other is penetrated by the two leads 36 has been described as an example, but the present invention is not limited to this structure. At least one of the two leads 36 provided in the sensor element 20 may penetrate through the portion where the first portion 24 and the second portion 26 overlap each other.

### [Modification of First Embodiment]

A modification of the first embodiment will be described below. Note that description of features that have already been described in the first embodiment will be omitted as appropriate. Constituent elements that have already been described in the first embodiment are denoted by the same reference characters as in the first embodiment.

### (Modification 1-1)

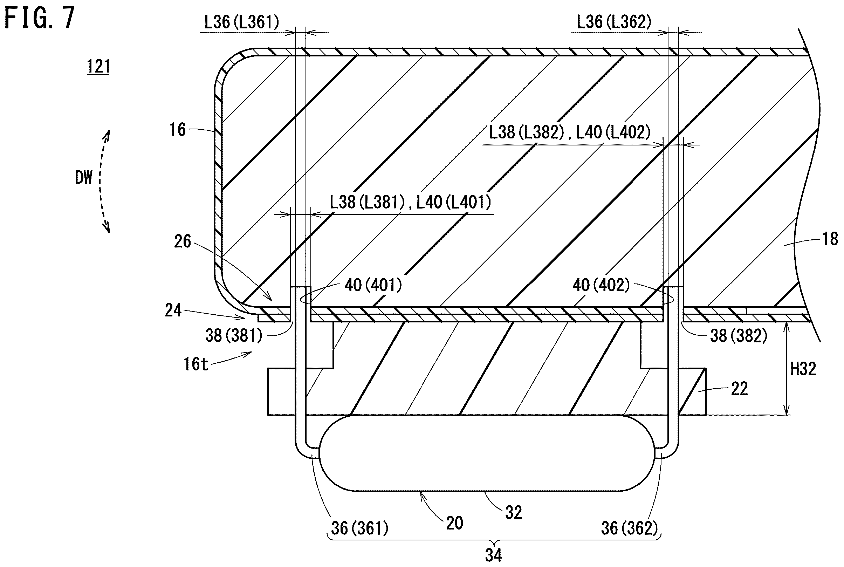

FIG. 7 is a diagram for explaining a sensor module 121 according to Modification 1-1.

As shown in FIG. 7, the spacer 22 may be disposed at a portion where the first portion 24 and the second portion 26 overlap each other. In other words, the sensor element 20 may be disposed via the spacer 22 at a portion where the first portion 24 and the second portion 26 overlap each other. The lead portion 34 that has penetrated through the spacer 22, penetrates through the first portion 24 and the second portion 26, and is inserted into the intermediate member 18. More specifically, the first lead 361 provided in the lead portion 34 is inserted into the first insertion hole 401 through the first through hole 381. The second lead 362 provided in the lead portion 34 is inserted into the second insertion hole 402 through the second through hole 382.

### (Modification 1-2)

In the example shown in FIG. 2, the case that each of the engagement portions 28 provided in the intermediate member 18 is configured by a concave portion has been described as an example, but the present invention is not limited to this structure. Each of the engagement portions 28 provided in the intermediate member 18 may be configured by a convex portion protruding from the intermediate member 18. In this case, the engagement portions 30 provided in the housing 14 have, for example, concave portions that engage with the convex portions.

### (Modification 1-3)

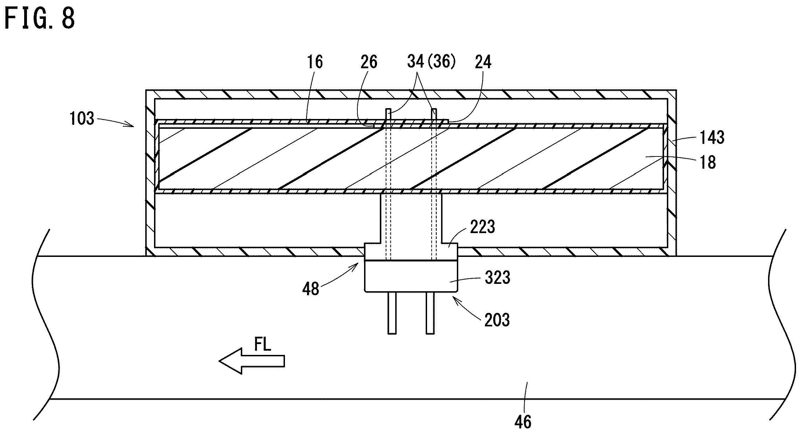

FIG. 8 is a diagram for explaining a sensor device 103 according to Modification 1-3.

The sensor device 103 includes a sensor element 203. As shown in FIG. 8, a main body portion 323 of the sensor element 203 is exposed without being accommodated in a housing 143. The main body portion 323 exposed from the housing 143 is disposed in a flow path 46 through which fluid FL flows. Accordingly, the main body portion 323 can detect the flow rate, the pressure, the temperature, and the like of the fluid FL by coming into contact with the fluid FL flowing in the flow path 46.

The housing 143 has an opening 48. The main body portion 323 of the sensor element 203 protrudes from the housing 143 to the outside through the opening 48. The housing 143 accommodates at least the flexible circuit board 16 and the intermediate member 18.

When the opening 48 is formed in the housing 143, there is a concern that the fluid FL may enter the housing 143 through the opening 48. The fluid FL that enters the housing 143 may adversely affect the flexible circuit board 16 (electric circuit), the intermediate member 18, and the like accommodated in the housing 143.

In view of this, in the present modification, the opening 48 is sealed by a spacer 223. Accordingly, it is possible to reduce the risk of the fluid FL entering the housing 143.

The housing 143 and the spacer 223 may have a heat insulating property. Accordingly, for example, it is possible to suppress the heat of the fluid FL transferred to the inside of the housing 143. Therefore, it is possible to reduce the concern that the heat of the fluid FL adversely affects the flexible circuit board 16 (electric circuit), the intermediate member 18, and the like disposed in the housing 143.

### (Modification 1-4)

The plurality of Modifications described above may be combined as appropriate to the extent that no contradictions arise.

### [Second Embodiment]

A second embodiment will be described below. Note that description overlapping with the first embodiment will be omitted as appropriate. In the present embodiment, constituent elements that have already been described in the first embodiment are denoted by the same reference characters unless otherwise specified.

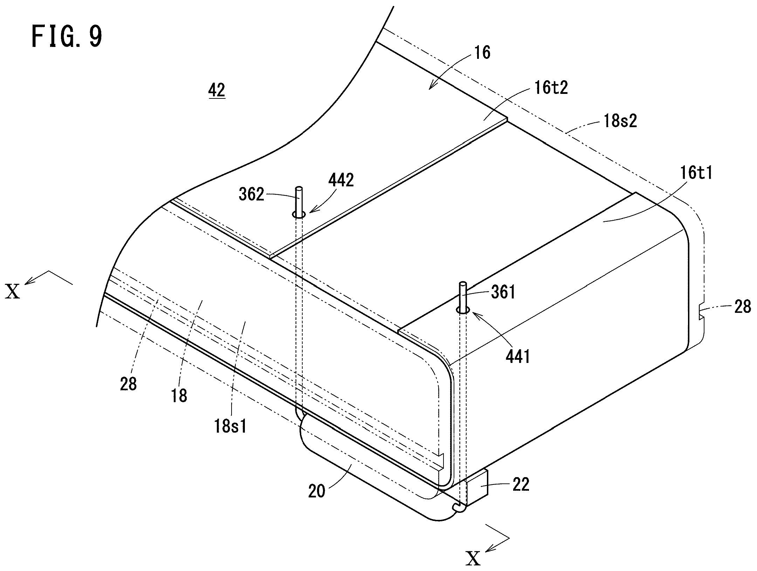

FIG. 9 is a perspective view of a sensor module 42 according to the second embodiment. Note that a part of the sensor module 42 is shown in FIG. 9.

The sensor module 42 includes the flexible circuit board 16, the intermediate member 18, the sensor element 20, and the spacer 22, similarly to the sensor module 12 according to the first embodiment. The sensor module 42 may be housed in the housing 14 (see FIGS. 1 and 2).

The flexible circuit board 16 has a first end portion 16t1 and a second end portion 16t2. The first end portion 16t1 is one end portion 16t of the flexible circuit board 16 in the longitudinal direction of the flexible circuit board 16. The second end portion 16t2 is another end portion 16t of the flexible circuit board 16 in the longitudinal direction.

In the present embodiment, the flexible circuit board 16 is wound around the intermediate member 18 such that the first end portion 16t1 and the second end portion 16t2 approach each other. The first end portion 16t1 and the second end portion 16t2 do not overlap each other in plan view. As described above, the present embodiment is different from the first embodiment in the way of winding the flexible circuit board 16 around the intermediate member 18.

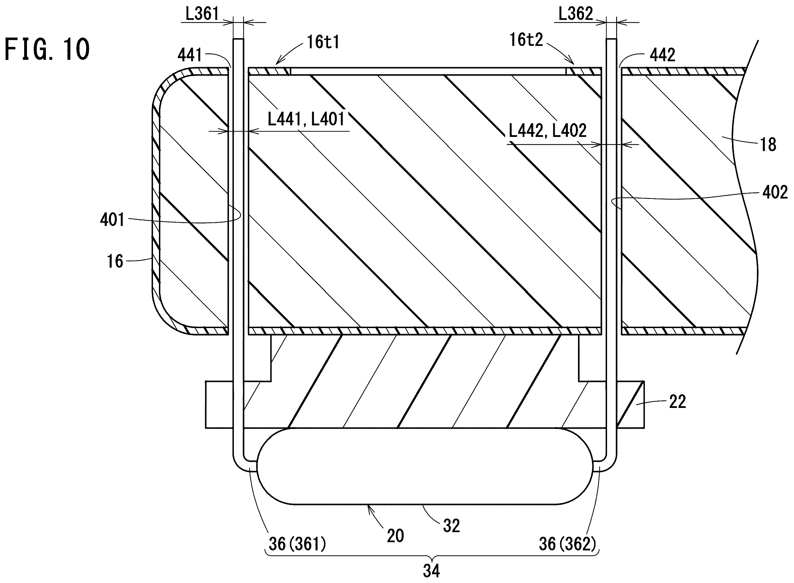

FIG. 10 is a cross-sectional view taken along line X-X of FIG. 9.

In the present embodiment, a first through hole 441 is formed in the first end portion 16t1 of the flexible circuit board 16. The first through hole 441 is a hole formed at a predetermined position in the first end portion 16t1 before the sensor element 20 is attached to the flexible circuit board 16. The first through hole 441 communicates with the first insertion hole 401 formed in the intermediate member 18. The first lead 361 provided in the sensor element 20 is inserted into the first through hole 441 via the first insertion hole 401.

Further, a second through hole 442 is formed in the second end portion 16t2 of the flexible circuit board 16. The second through hole 442 is a hole formed at a predetermined position in the second end portion 16t2 before the sensor element 20 is attached to the flexible circuit board 16. The second through hole 442 communicates with the second insertion hole 402 formed in the intermediate member 18. The second lead 362 provided in the sensor element 20 is inserted into the second through hole 442 via the second insertion hole 402.

In this manner, the first lead 361 is inserted into the intermediate member 18, and the second lead 362 is inserted into the intermediate member 18. Thus, the sensor element 20 is positioned with respect to the intermediate member 18.

The sensor element 20 also functions as a fixture for fixing the first end portion 16t1 and the second end portion 16t2 of the flexible circuit board 16 to the intermediate member 18. Accordingly, the flexible circuit board 16 is positioned with respect to the intermediate member 18. Moreover, the first lead 361 protrudes from the first end portion 16t1. Therefore, the first lead 361 and the flexible circuit board 16 can be easily connected by soldering the first lead 361 and the first end portion 16t1. The second lead 362 protrudes from the second end portion 16t2. Therefore, the second lead 362 and the flexible circuit board 16 can be easily connected by easily soldering the second lead 362 and the second end portion 16t2.

A diameter L441 of the first through hole 441 is preferably larger than a diameter L361 of the first lead 361. This facilitates insertion of the first lead 361 into the first through hole 441. Similarly, a diameter L442 of the second through hole 442 is preferably larger than a diameter L362 of the second lead 362. This facilitates insertion of the second lead 362 into the second through hole 442.

In the present embodiment, the diameter L441 of the first through hole 441 and the diameter L401 of the first insertion hole 401 are equal to each other, but the present invention is not limited thereto. Similarly, in the present embodiment, the diameter L442 of the second through hole 442 and the diameter L402 of the second insertion hole 402 are equal to each other, but the present invention is not limited thereto.

### [Modification of Second Embodiment]

A modification of the second embodiment will be described below. Note that description of features that have already been described in the second embodiment will be omitted as appropriate. Constituent elements that have already been described in the second embodiment are denoted by the same reference characters as in the second embodiment.

### (Modification 2-1)

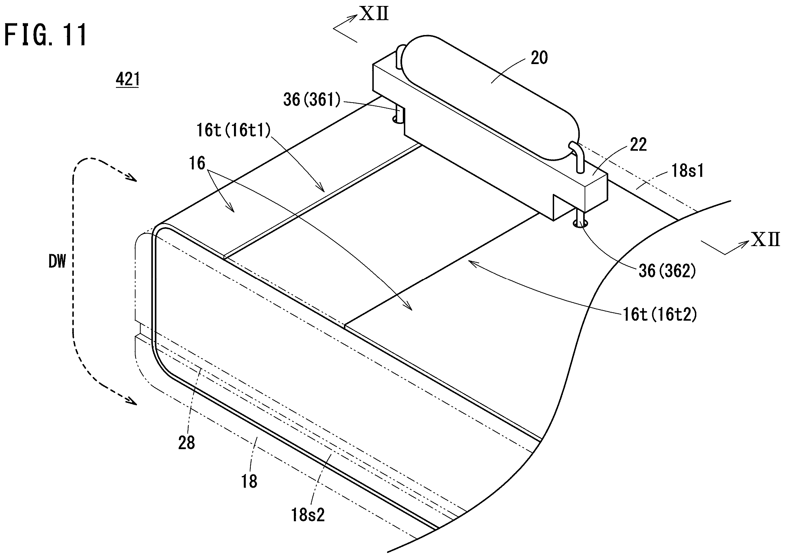

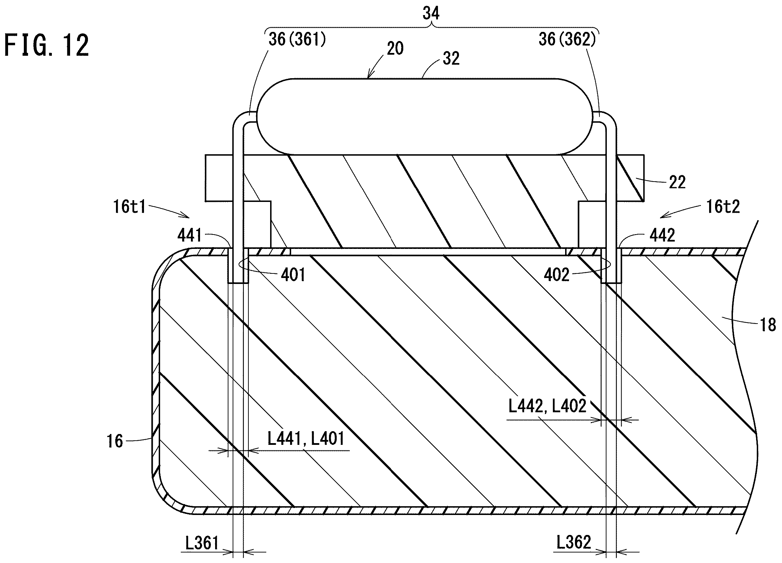

FIG. 11 is a perspective view illustrating a sensor module 421 according to Modification 2-1. FIG. 12 is a cross-sectional view taken along line XII-XII in FIG. 11.

In the present modification, the first lead 361 penetrates the first end portion 16t1 and further penetrates the intermediate member 18. The first lead 361 is fixed to the first end portion 16t1 by, for example, soldering. Thus, the first end portion 16t1 is fixed to the intermediate member 18 via the first lead 361.

The second lead 362 penetrates the second end portion 16t2 and further penetrates the intermediate member 18. The second lead 362 is fixed to the second end portion 16t2 by, for example, soldering. Thus, the second end portion 16t2 is fixed to the intermediate member 18 via the second lead 362.

### (Modification 2-2)

In the example shown in FIG. 9, the case that each of the engagement portions 28 provided in the intermediate member 18 is configured by a concave portion has been described as an example, but the present invention is not limited to this structure. Each of the engagement portions 28 provided in the intermediate member 18 may be configured by a convex portion protruding from the intermediate member 18. In this case, the engagement portions 30 provided in the housing 14 have, for example, concave portions that engage with the convex portions.

### (Modification 2-3)

The plurality of Modifications described above may be combined as appropriate to the extent that no contradictions arise.

### [Invention That Can Be Grasped from Embodiments]

The invention that can be grasped from the above-described embodiments and modifications will be described below.

### <Supplementary Note 1>

The sensor module (12) includes the intermediate member (18), the flexible circuit board (16) wound around the intermediate member, and the sensor element (20) including the lead portion (34) penetrating the flexible circuit board and inserted into the intermediate member, wherein the flexible circuit board is wound around the intermediate member in a manner so that the first portion (24) of the flexible circuit board overlaps and contacts the second portion (26) of the flexible circuit board, the second portion being different from the first portion, and the lead portion penetrates the first portion and the second portion and is inserted into the intermediate member. In accordance with such features, it is possible to provide a sensor module that can be configured favorably and simply even when a flexible circuit board is used.

### <Supplementary Note 2>

In the sensor module according to Supplementary Note 1, the lead (36) provided in the lead portion may be inserted into the insertion hole (40) formed in the intermediate member, and the diameter (L36) of the lead may be smaller than the diameter (L40) of the insertion hole. In accordance with such features, it is possible to insert the lead into the insertion hole.

### <Supplementary Note 3>

In the sensor module according to Supplementary Note 1 or 2, the lead (36) provided in the lead portion may be inserted into the through hole (38) formed in the flexible circuit board, and the diameter (L36) of the lead may be smaller than the diameter (L38) of the through hole. In accordance with such features, it is possible to insert the lead into the through hole.

### <Supplementary Note 4>

The sensor module (42) includes the intermediate member (18), the flexible circuit board (16) wound around the intermediate member, and the sensor element (20) including the lead portion (34) penetrating the flexible circuit board and inserted into the intermediate member, wherein the flexible circuit board is wound around the intermediate member in a manner so that the first end portion (16t1) of the flexible circuit board and the second end portion (16t2) of the flexible circuit board approach each other, and the lead portion includes the first lead (361) penetrating the first end portion and inserted into the intermediate member, and the second lead (362) penetrating the second end portion and inserted into the intermediate member. In accordance with such features, it is possible to provide a sensor module that can be configured favorably and simply even when a flexible circuit board is used.

### <Supplementary Note 5>

In the sensor module according to Supplementary Note 4, the first lead may be inserted into the first insertion hole (401) formed in the intermediate member, and the second lead may be inserted into the second insertion hole (402) formed in the intermediate member, and the diameter (L361) of the first lead may be smaller than the diameter (L401) of the first insertion hole, and the diameter (L362) of the second lead may be smaller than the diameter (L402) of the second insertion hole. In accordance with such features, it is possible to insert the first lead into the first insertion hole and the second lead into the second insertion hole.

### <Supplementary Note 6>

In the sensor module according to Supplementary Note 4 or 5, the first lead may be inserted into the first through hole (441) formed in the flexible circuit board, and the second lead may be inserted into the second through hole (442) formed in the flexible circuit board, and the diameter (L361) of the first lead is smaller than the diameter (L441) of the first through hole, and the diameter (L362) of the second lead may be smaller than the diameter (L442) of the second through hole. In accordance with such features, it is possible to insert the first lead into the first through hole and the second lead into the second through hole.

### <Supplementary Note 7>

In the sensor module according to any one of Supplementary Notes 1 to 6, the lead portion need not necessarily penetrate the intermediate member. In accordance with such features, the tip of the lead portion is reliably insulated.

### <Supplementary Note 8>

The sensor module according to any one of Supplementary Notes 1 to 7 may further include the spacer (22) disposed between the flexible circuit board and the main body portion (32) that is included in the sensor element. In accordance with such features, the separation distance between the flexible circuit board and the main body portion can be maintained at a certain distance or more.

### <Supplementary Note 9>

In the sensor module according to any one of Supplementary Notes 1 to 8, the intermediate member may include the engagement portion (28) configured to engage with the housing (14) configured to accommodate the sensor module. In accordance with such features, it is possible to fix the intermediate member to the housing.

### <Supplementary Note 10>

The sensor device (10) includes the sensor module according to any one of Supplementary Notes 1 to 9, and the housing (14, 143) configured to accommodate at least the flexible circuit board and the intermediate member of the sensor module.

It should be noted that the present invention is not limited to the disclosure described above, and various configurations could be adopted therein without departing from the essence and gist of the present invention.

### [REFERENCE SIGNS LIST]

- 10, 103:: device
- 12, 42, 121, 421:: sensor module
- 14, 143:: housing
- 16:: flexible circuit board
- 16t:: end portion
- 16t1:: first end portion
- 16t2:: second end portion
- 18:: intermediate member
- 20, 203:: sensor element
- 22, 221, 223:: spacer
- 24:: first portion
- 26:: second portion
- 28, 30:: engagement portion
- 32, 323:: main body
- 34:: lead portion
- 36:: lead
- 38:: through hole
- 40:: insertion hole
- 46:: flow path
- 48:: opening
- 361:: first lead
- 362:: second lead
- 381:: first through hole
- 382:: second through hole
- 401:: first insertion hole
- 402:: second insertion hole
- 441:: first through hole
- 442:: second through hole
- FL:: fluid

## Claims

1. A sensor module (12) comprising:
an intermediate member (18);
a flexible circuit board (16) wound around the intermediate member; and
a sensor element (20) including a lead portion (34) penetrating the flexible circuit board and inserted into the intermediate member,
wherein the flexible circuit board is wound around the intermediate member in a manner so that a first portion (24) of the flexible circuit board overlaps and contacts a second portion (26) of the flexible circuit board, the second portion being different from the first portion, and
the lead portion penetrates the first portion and the second portion and is inserted into the intermediate member.

2. The sensor module according to claim 1, wherein a lead (36) provided in the lead portion is inserted into an insertion hole (40) formed in the intermediate member, and
a diameter (L36) of the lead is smaller than a diameter (L40) of the insertion hole.

3. The sensor module according to claim 1, wherein a lead (36) provided in the lead portion is inserted into a through hole (38) formed in the flexible circuit board, and
a diameter (L36) of the lead is smaller than a diameter (L38) of the through hole.

4. A sensor module (42) comprising:
an intermediate member (18);
a flexible circuit board (16) wound around the intermediate member; and
a sensor element (20) including a lead portion (34) penetrating the flexible circuit board and inserted into the intermediate member,
wherein the flexible circuit board is wound around the intermediate member in a manner so that a first end portion (16t1) of the flexible circuit board and a second end portion (16t2) of the flexible circuit board approach each other, and
the lead portion includes a first lead (361) penetrating the first end portion and inserted into the intermediate member, and a second lead (362) penetrating the second end portion and inserted into the intermediate member.

5. The sensor module according to claim 4, wherein the first lead is inserted into a first insertion hole (401) formed in the intermediate member, and the second lead is inserted into a second insertion hole (402) formed in the intermediate member, and
a diameter (L361) of the first lead is smaller than a diameter (L401) of the first insertion hole, and a diameter (L362) of the second lead is smaller than a diameter (L402) of the second insertion hole.

6. The sensor module according to claim 4, wherein the first lead is inserted into a first through hole (441) formed in the flexible circuit board, and the second lead is inserted into a second through hole (442) formed in the flexible circuit board, and
a diameter (L361) of the first lead is smaller than a diameter (L441) of the first through hole, and a diameter (L362) of the second lead is smaller than a diameter (L442) of the second through hole.

7. The sensor module according to any one of claims 1 to 6, wherein the lead portion does not penetrate the intermediate member.

8. The sensor module according to any one of claims 1 to 6, further comprising a spacer (22) disposed between the flexible circuit board and a main body portion (32) that is included in the sensor element.

9. The sensor module according to any one of claims 1 to 6, wherein the intermediate member includes an engagement portion (28) configured to engage with a housing (14) configured to accommodate the sensor module.

10. A sensor device (10) comprising:
the sensor module according to claim 1 or 4; and
a housing (14, 143) configured to accommodate at least the flexible circuit board and the intermediate member of the sensor module.
